Europäisches Patentamt

European Patent Office

Office européen des brevets

(19)

(11) Publication number: **0 040 942**
**A1**

**EP 0 040 942 A1**

(12) **EUROPEAN PATENT APPLICATION**

(21) Application number: **81302187.0**

(22) Date of filing: **18.05.81**

(51) Int. Cl.³: **H 01 R 23/72**, H 01 R 9/09

(30) Priority: **27.05.80 US 153514**
**18.12.80 US 217932**

(43) Date of publication of application: **02.12.81**
**Bulletin 81/48**

(84) Designated Contracting States: **AT BE CH DE FR GB IT**
**LI NL SE**

(71) Applicant: **AMP INCORPORATED, Eisenhower Boulevard, Harrisburg, Pennsylvania (US)**

(72) Inventor: **Andrews, Howard Wallace, Jr., 828 East Chocolate Avenue, Hershey Pennsylvania 17033 (US)**
Inventor: **Cobaugh, Robert Franklin, Box 144A R.D. No.2, Elizabethtown Pennsylvania 17022 (US)**
Inventor: **Graeff, Norwood Claude, 375 North 48th Street, Harrisburg Pennsylvania 17111 (US)**

(74) Representative: **Wayte, Dennis Travers et al, 20 Queensmere, Slough, Berkshire SL1 1YZ (GB)**

(54) **Electrical contact receptacle for substrate to printed circuit board connection.**

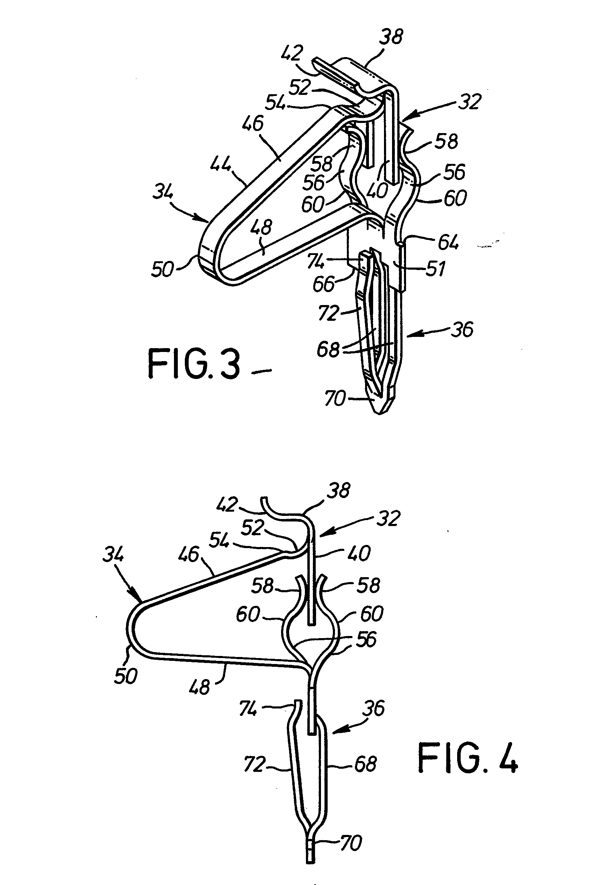

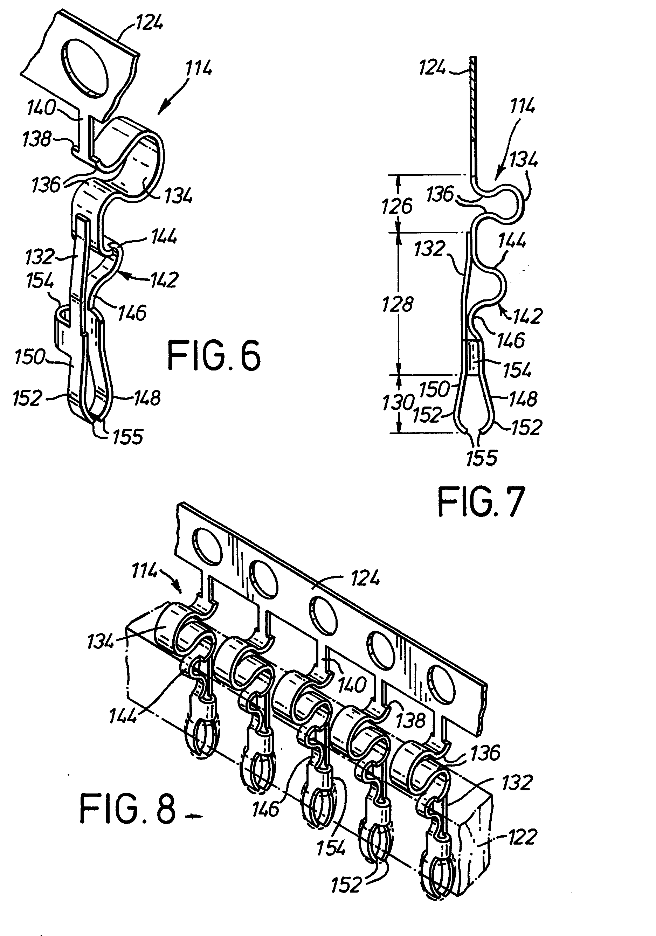

(57) A contact receptacle for substrate to circuit board connection comprises a receptacle for an edge of the substrate and a post for insertion in a board aperture integrally joined by an intermediate section comprising a resilient portion (34, Figure 3) adapted to allow relative movement between the receptacle (32) and post (36) and extensions (40, 56) of the receptacle and the post which overlap in sliding contact to provide a short electrical path between the substrate and the board. The resilient portion may comprise a generally hair-pin spring form (46, 48, 50) having a bight (50) spaced substantially from the post (36). In an alternative (Figure 8) the resilient portion (144) is of reduced width and of sinuous form, with the intermediate section embedded in the elastomer (22).

0040942
9402

Electrical Contact Receptacle for Substrate to Printed Circuit Board Connection.

This invention relates to a contact receptacle for mounting a substrate on and electrically connecting it to a printed circuit board.

It is important to provide a short circuit path between the substrate and the circuit board but due to warpage of circuit boards or flexure resulting from mechanical or thermal stress, stresses may be imposed on the substrate causing failure.

An object of the invention is to provide a contact receptacle capable of defining a short electrical path between a substrate and a circuit board and accommodating relative movement between the board and the substrate as might be occasioned by board warpage with protection against stress on the substrate.

According to the invention a contact receptacle formed from sheet metal for mounting a substrate on and electrically connecting it to a printed circuit board and comprising a receptacle portion for receiving an edge of the substrate and a post portion for reception in a printed circuit board aperture, the receptacle and post portions being integrally joined by an intermediate section, is characterised in that the intermediate section comprises a spring portion of generally C-form with limbs extending laterally of the post portion, at one end integral with the receptacle portion and at the other with the post portion, for relative movement of the receptacle and the post by flexure of the spring portion, an extension of the receptacle portion slidably engaging an extension of the post portion at an interface extending lengthwise relative to the post portion.

In one embodiment the interemediate section comprises an upper limb extending obliquely downwardly from the receptacle and a lower limb extending generally obliquely upwardly from the post at a lesser inclination, the limbs being joined by an arcuate bight spaced substantially from the post.

In a second embodiment the extension of the post portion comprises a tongue bridging the spring portion and at an end slidably engaging an extension of the receptacle disposed between the receptacle and spring portions, the tongue being resiliently biased against the extension.

Suitably the spring portion is of reduced width and the intermediate section including the spring portion and the major part of the tongue are embedded in elastomeric material from which the post portion, the receptacle portion and the engaged end of the tongue and the extension project externally.

The invention will now be described by way of example with reference to the accompanying partly diagrammatic drawings, in which:-

Figure 1 is a fragmentary perspective view of a ceramic substrate mounted on and electrically connected to a printed circuit board by contact receptacles according to a first embodiment of the invention;

Figure 2 is a view showing the assembly of the arrangement of Figure 1;

Figure 3 is a perspective view to an enlarged scale of a contact receptacle of the arrangement of Figure 1;

Figure 4 is a side elevation of the contact receptacle of Figure 3;

Figure 5 is a fragmentive perspective view of a contact receptacle according to Figures 3 and 4 during successive stages of forming;

Figure 6 is a perspective view similar to that of Figure 3 of a contact receptacle according to a second embodiment of the invention;

Figure 7 is a side elevation of the contact receptacle of Figure 6;

Figure 8 is a fragmentary perspective view of a series of contact receptacles according to Figures 6 and 7 integrally joined by a severable carrier strip and having portions embedded in elastomeric insulating material;

Figure 9 is a fragmentary cross-sectional elevation of part of the contact assembly of Figure 8;

Figure 10 is a fragmentary sectional elevation corresponding to part of Figure 9 of a contact receptacle mounted in a printed circuit board aperture;

Figure 11 is a perspective view of a ceramic substrate mounted on and electrically connected to a printed circuit board by contact receptacles of the second embodiment, and

Figure 12 is a flat development of a metal blank from which the contact receptacle of Figures 6 and 7 is formed.

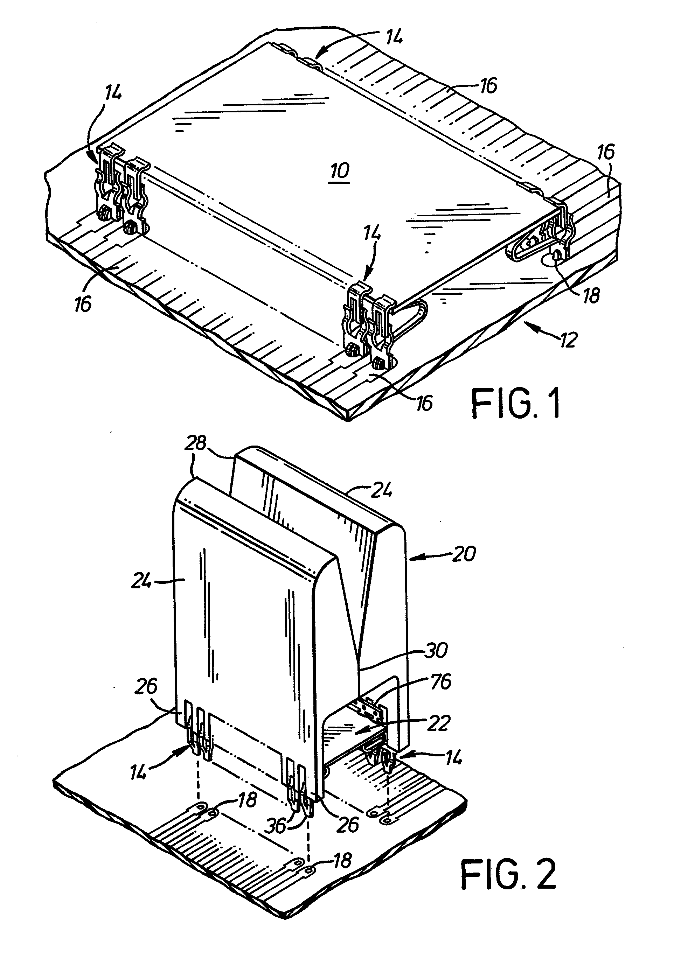

In the assembly of Figure 1 an active device substrate 10 is mechanically supported on and electrically connected to a printed circuit board 12 by a plurality of contact receptacles 14 each electrically connecting a contact pad (not shown) on the underside of the substrate 10 to a respective conductive track 16 on the printed circuit board 12. The printed circuit board 12 is formed with plated-through holes 18 into which resilient post portions of the receptacles 14 are fitted. Receptacle portions of the contact receptacles 14 engage edges of the substrate 10 which is suitably assembled to the printed circuit board 12 by means of a tool 20 as shown in Figure 2 in order to reduce risk of damage to the substrate 10 which generally will be relatively fragile. The tool 20 is suitably of plastics moulding and comprises two arms 24 having toothed or slotted forward ends 26 and hinged together at 30 intermediate the forward and rearward ends 26, 28, with the forward ends biased together by a spring not shown. The tool is arranged to grip the substrate 10 at a pair of opposite edges with the toothed or slotted portions 26 interdigitating with the contact receptacles 14, of which resilient post portions 36 project downwardly below the tool. The post portions 36 are aligned with respective plated-through holes 18 and the substrate urged downwardly by the tool to drive the post portions 36 into the holes 18. The tool then being released.

As shown in Figures 3 and 4, each contact receptacle is formed from sheet metal, for example a copper based alloy of 0.008 inches (0.203 mm), and comprises an upper receptacle portion 32, a lower post portion 36 and an intermediate spring section 34. The receptacle portion is of generally U-form with an upper limb 38 turned up at its free end to provide a downwardly facing arcuate convex surface 42, and a lower limb 52 of reduced width integrally formed with the intermediate spring section 34 at a junction bent to define an upwardly directed arcuate contact portion 54 for engagement with a substrate contact pad. The receptacle portion 32 has two upright extensions 40 projecting downwardly on opposite sides of the lower limb 52 from its junction with the upper limb 38.

The intermediate section 34 is of generally hairpin spring form having a bight 50 and an upper limb inclined upwardly more steeply than a lower limb 48 is inclined downwardly. The upper limb 46 extends integrally from the lower limb of the receptacle portion 32, and the lower limb 48, remote from the bight 50, is integrally formed with a strap portion 51 extending transversely and defining an upper end to the lower section 36. The post portion 36 extends downwards from the strap portion 51 and is formed with a pushed out limb 72 having an upper free end 74 and integrally formed at its lower end with the post portion between upright limbs 68 integral at their upper ends with the strap portion. The limbs 68 and the limb 72 are bowed in opposite senses for resilient flexure of limbs 68 and limb 72 towards each other. The limbs 68 converge at their lower ends to provide a bevelled tip 70 to facilitate board insertion, and the limbs 68 may be flexed towards each other on board insertion. The strap 51 extends beyond the limbs 68 to define down-facing shoulders 66 to limit board insertion.

On its upper side, the strap 51 is formed on each side of spring limb 48 with an upwardly extending spring finger 56. The fingers 56 are bent in sinuous fashion, in opposite senses, to present spring segments 60 projecting convexly away from each other and arcuate contact portions 58 convex towards each other as seen in Figure 4. The extensions 40 of the receptacle portion 32 engage respective contact portions 58 on opposite sides, and the spring sections 60 are suitably so formed that the contact portions 58 exert firm contact pressure against the extensions 40 to maintain good, sliding electrical contact. The strap 51 projects beyond the spring fingers 56 to define up-facing shoulders 64 which provide support for the insertion tool of Figure 2.

The contact portion 54 is suitably plated with gold or silver to facilitate contact with a substrate pad, and may carry a solder ring if permanent contact is desired.

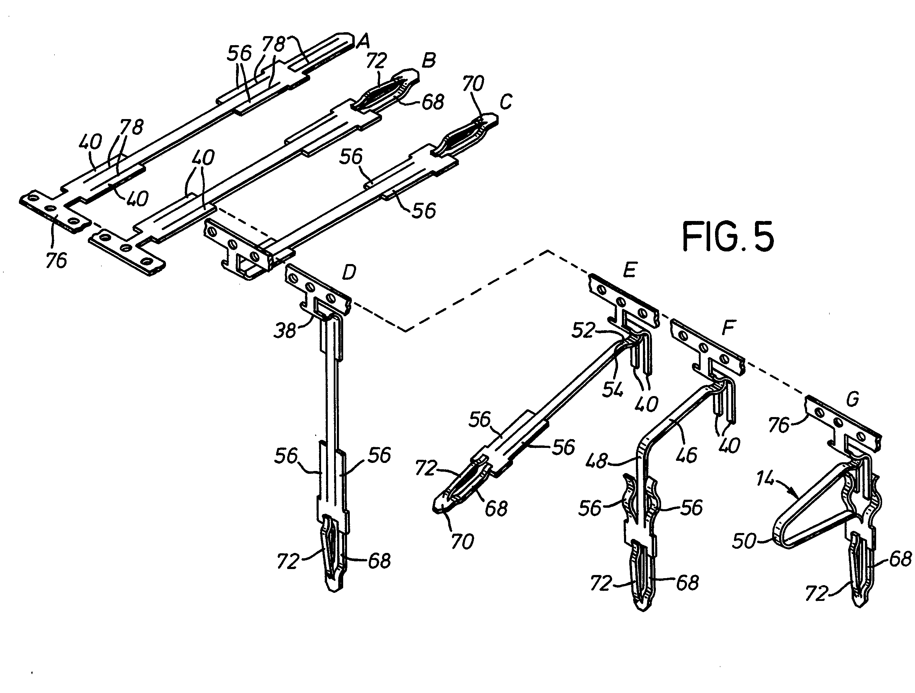

The contact receptacles are suitably formed in continuous strip form as generally shown in Figure 5. Initially at A the receptacle is formed in flat blank form extending at the end of the receptacle portion from an integral carrier strip 76 with severed lines 78 defining the extensions 40, post limb 72 and springs 56 in flat form. In this condition the strip may be selectively plated to plate desired contact zones. In a second step B the limbs 72 and 68 of the post portion are bowed away from each other, and in the third step C the upper limb of the receptacle portion is bent to form the entry portion 38 and then in steps D and E further bent in a reverse sense to form the bight of the receptacle portion and the contact portion 54. In the subsequent step F the bight of the spring section 34 is semi-formed together with formation of spring portion 56. Finally, in step G the bight of section 34 is completed and the extensions 40 engaged with contact portions of springs 56.

The elongated spring 44 serves to protect the substrate from stress which might result from warpage of or mechanical or thermal stresses in the printed circuit board. The engaged fingers 40, 56 define a short signal path between the substrate and the board.

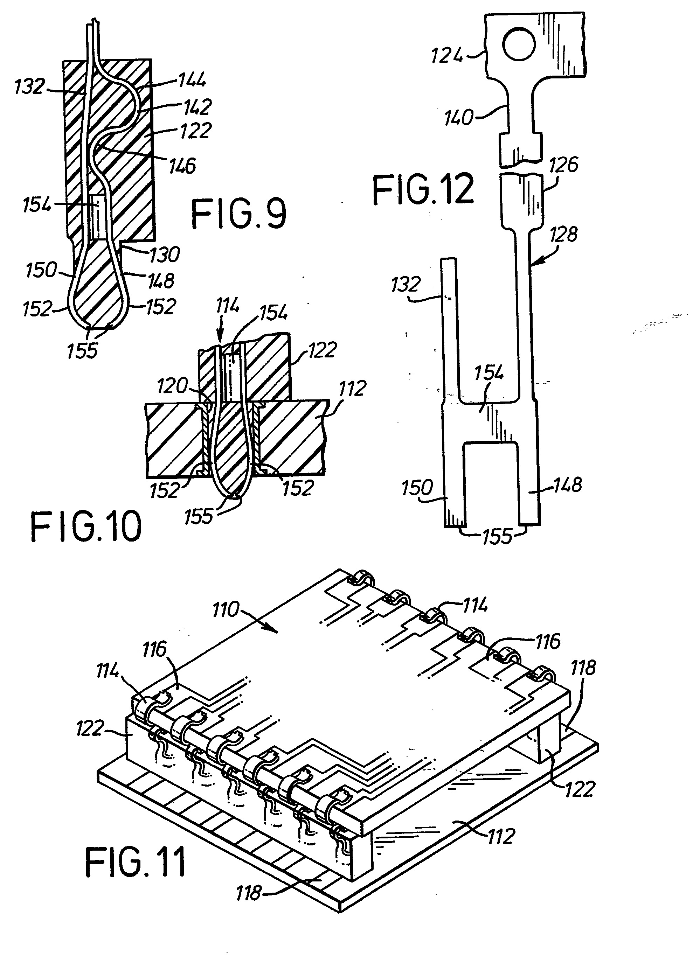

In the assembly of Figure 11 a substrate 110 is supported on and electrically connected to a printed circuit board 112 by a plurality of contact receptacles 114 which connect respective contact pads 116 of the substrate to circuit paths 118 of the board at plated through holes 120 as seen in Figure 10. The receptacles are as shown in Figures 6 and 7 and extend through elastomeric insulating blocks 122 within which they are embedded as seen more clearly in Figures 8 and 9.

The contact receptacles 114 are stamped and formed from sheet metal in strip form to provide a plurality of receptacles extending at intervals from a carrier strip 124 at severable neck portions 140. Initially the receptacles are stamped out in flat blank form as shown in Figure 12 which is subsequently formed and folded to define the contact receptacle shown in Figures 6 and 7. Each receptacle 114 comprises an upper receptacle section 126, an intermediate section 128, a lower post section 130 for insertion in a printed circuit board plated through hole, and a shorting bar 132. The receptacle section 126 comprises a C-shaped receptacle 134 having arcuately convex facing contact portions 136 for engaging opposite faces of the substrate 110. The upper end 138 of the receptacle portion is secured to the carrier strip 124 by the neck portion 140 which is of reduced width and suitably scored transversely, not shown, to facilitate subsequent severing. The lower end of the receptacle is bent downwardly to present a generally upright portion leading downwardly to a sinuous portion 142 of reduced width having an upper, larger section, concave towards the shorting bar 132, and a lower, smaller section 46, convex towards the shorting bar 132 and leading to the post section 130.

The post section 130 comprises a pair of legs 148, 150 depending from a transverse strap portion 154 which supports the shorting bar 132. The strap 154 is bent to position the legs in opposed spaced relation, and the legs are bent arcuately in facing concave manner with their lower ends 155 converging.

The shorting bar 132 bridges the sinuous portion 142 and at its upper end slidably engages the upright section between the receptacle 134 and the sinuous portion 142, and also engages the lower section 146 of the sinuous portion. The bar 132 and strap 154 are suitably so formed that the shorting bar 132 engages the upright section and the lower section 146 with resilient force or preloading.

As shown in Figure 8, the receptacles are suitably encased in an elastomeric block 122 of insulating material, such as a silicone rubber, which is moulded as a continuous strip about a strip of receptacles, completely to embed the intermediate sections 128, and to extend between the opposed legs 148, 150 of the post sections, leaving outer faces 152 of the legs exposed. The receptacle portions 134, the upper end of the shorting bar and the engaged portion of the upright section project externally of the elastomeric block. As shown in Figure 10 the post section is, in use, inserted into a plated through hole 120 of the circuit board to engage the exposed faces of the legs 148, 150 with the plated sides of the hole with inward flexure of the legs

0040942

9402

and the intervening elastomeric material. Suitably the elastomeric material is formed to extend externally of the upper portions of the legs, to serve as a plug sealing the upper end of the hole.

The shorting bar 132 serves to provide a short, low resistance electrical path between the receptacle section and the post section, and the sinuous section 142 of reduced width provides a resilient readily deformable section for accommodating relative movement between the substrate and the board, due, for example to board warpage, whilst protecting the substrate from stress. The sinuous section is resiliently supported by the elastomeric material.

Claims:-

1. A contact receptacle formed from sheet metal for mounting a substrate on and electrically connecting it to a printed circuit board and comprising a receptacle portion (32) for receiving an edge of the substrate and a post portion (36) for reception in a printed circuit board aperture, the receptacle and post portions being integrally joined by an intermediate section (34), characterised in that the intermediate section (34) comprises a spring portion (46, 48, 50) of generally C-form with limbs (46, 48) extending laterally of the post portion (36), at one end integral with the receptacle portion (32) and at the other with the post portion (36), for relative movement of the receptacle (32) and the post (36) by flexure of the spring portion (46, 48, 50), an extension (40) of the receptacle portion (32) slidably engaging an extension (56) of the post portion (36) at an interface extending lengthwise relative to the post portion (36).

2. A receptacle as claimed in claim 1, characterised in that the intermediate section (34) comprises an upper limb (46) extending obliquely downwardly from the receptacle (32) and a lower limb (48) extending generally obliquely upwardly from the post (36) at a lesser inclination, the limbs (46, 48) being joined by an arcuate bight (50) spaced substantially from the post (36).

3. A receptacle as claimed in claim 1, or claim 2, characterised in that fingers (40) extend downwardly from opposite sides of the receptacle (32), and a pair of sinuous spring members (56) project upwardly from the post (36), the spring members (56) engaging respective fingers (40) on opposite sides to define sliding electrical contact between the receptacle (32) and the post (36).

4. A receptacle as claimed in claim 1, characterised in that the extension (132) of the post portion (130) comprises a tongue bridging the spring portion (142) and at

0040942
9402

an end slidably engaging an extension of the receptacle (34) disposed between the receptacle (34) and spring portions (42), the tongue (132) being resiliently biased against the extension.

5.    A receptacle as claimed in claim 4, <u>characterised in that</u> the spring portion (142) is of reduced width and the intermediate section (128) including the spring portion (42) and the major part of the tongue (132) are embedded in elastomeric material (122) from which the post portion (130), the receptacle portion (126) and the engaged end of the tongue (132) and the extension project externally.

FIG. 1

FIG. 2

0040942

2/5

FIG. 3 –

FIG. 4

FIG.5

415

FIG.6

FIG.7

FIG.8

515

FIG.9

FIG.10

FIG.12

FIG.11

European Patent Office

**EUROPEAN SEARCH REPORT**

0040942

Application number

EP 81 30 2187.0

| Category | Citation of document with indication, where appropriate, of relevant passages | Relevant to claim |
|---|---|---|
| | US - A - 4 045 105 (LEE et al.) <br> * column 3, lines 19 to 44, column 4, lines 1 to 5, column 5, line 17 to column 6, line 6; fig. 1 to 5 * | 1,2,4 |
| | --- | |
| | US - A - 4 161 346 (CHERIAN et al.) <br> * column 2, lines 1 to 31; fig. 1 * | 4 |
| | --- | |
| | FR - A1 - 2 424 689 (COMATEL) <br> * page 3, line 9 to page 5, line 7; fig. 1 to 8 * | 1 |
| | --- | |
| A | US - A - 4 203 648 (SEIDLER) <br> * column 3, lines 7 to 15; fig. 7 * | |
| | --- | |
| A | DE - A1 - 2 805 618 (AMP) <br> * claims 1, 3, 5; fig. 1 to 6 * | |
| | ----- | |

**DOCUMENTS CONSIDERED TO·BE RELEVANT**

**CLASSIFICATION OF THE APPLICATION (Int. Cl.³)**

H 01 R 23/72
H 01 R 9/09

**TECHNICAL FIELDS SEARCHED (Int. Cl.³)**

H 01 R 9/09
H 01 R 23/70
H 01 R 23/72
H 05 K 7/02
H 05 K 7/10

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

| | The present search report has been drawn up for all claims | | |
|---|---|---|---|
| **Place of search** <br> Berlin | **Date of completion of the search** <br> 25-08-1981 | **Examiner** <br> HAHN | |

EPO Form 1503.1 06.78